# EUROPEAN PATENT SPECIFICATION

(11) **EP 3 189 097 B1**
(45) Date of publication and mention of the grant of the patent: **11.03.2020**
(21) Application number: 15837858.8
(22) Date of filing: 05.06.2015
(51) Int. Cl.: C08K 3/22, C23C 18/06, C23C 18/20, C08L 77/06, C08L 69/00, C08L 67/02

(54) **USE OF NIOBIUM DOPED TIN OXIDE**
VERWENDUNG VON MIT NIOB DOTIERTEM ZINNOXID
UTILISATION D'OXYDE D'ÉTAIN DOPÉ AU NIOBIUM

(30) Priority: 04.09.2014 CN 201410448481; 04.09.2014 CN 201410449096
(43) Date of publication of application: 12.07.2017
(73) Proprietor: BYD Company Limited, Shenzhen, Guangdong 518118 (CN)
(72) Inventor: ZHOU, Wei, Shenzhen Guangdong 518118 (CN); MAO, Bifeng, Shenzhen Guangdong 518118 (CN)
(74) Representative: Gulde & Partner
(86) International application number: PCT/CN2015/080926
(87) International publication number: WO 2016/034000

(56) References cited:
- WO-A1-95/20689
- WO-A1-2014/042071
- WO-A2-02/079542
- CN-A- 103 183 978
- CN-A- 103 757 615
- CN-A- 104 275 886
- CN-A- 104 311 873
- JP-A- H01 150 150
- US-A1- 2012 111 409
- US-A1- 2013 168 133

## Description

The present invention refers to the use of a doped tin oxide as a chemical plating promoter.

### BACKGROUND

Providing a metal layer on a selected area of a surface of an insulating substrate such as a plastic in order to form a passage for transmitting electro-magnetic signals is widely applied in the field of automobile, computer, communications, and so on.

There are various methods to form a metal layer on the surface of the insulating substrate such as a plastic, which should be further improved. JP H01 150150 A discloses a conductive substrate comprising an undercoat layer including a metal oxide and a binder resin. The metal oxide may be SnO₂ doped with Nb. US 2013/0168133 teaches mica coated with Sb:SnO₂ as LDS agent for selective electroless deposition.

### SUMMARY

In viewing thereof, the present disclosure is directed to solve at least one problem existing in the art, for example, the shortcomings of low plating speed and being easy to appear leakage of plating involved in some conventional methods for selective metallization on a surface of the insulating substrate such as plastic to form a metal layer via chemical plating, which use metal oxides with light color as chemical plating promoters.

The present invention is based on the following founding of the inventors:
A doped tin oxide with niobium as doping element has a better ability to promote chemical plating, and when using it as a chemical plating promoter, a higher plating speed may be obtained and a continuous metal layer may be formed together with higher adhesive between the metal layer and the insulating substrate. And additionally presetting a doped tin oxide with niobium as doping element in an insulating substrate such as polymer will not or substantially will not interfere the color of the insulating substrate.

The present invention refers to the use of a doped tin oxide as a chemical plating promoter in selectively metallizing a surface of an insulating substrate, and in some embodiments of present disclosure, a doping element of the doped tin oxide includes niobium, and the doped tin oxide has a coordinate L* value of 70 to 100, a coordinate a value of -5 to 5, and a coordinate b value of -5 to 5 in a CIELab color space.

In some embodiments, the doped tin oxide has a reflectivity of no more than 60 % to a light with a wavelength of 1064 nm.

In some embodiments, the doped tin oxide has a coordinate L* value of 80 to 90, a coordinate a value of -5 to 2, and a coordinate b value of 2 to 4 in a CIELab color space.

In some embodiments, based on the total weight of the doped tin oxide, the content of the tin oxide is 70 wt% to 99.9 wt%, and the content of the niobium is 0.1 wt% to 30 wt% calculated as Nb₂O₅.

Embodiments not falling under the claimed invention refer to a polymer composition. The polymer composition includes a polymer and a doped tin oxide, based on 100 weight parts of the polymer, the content of the doped tin oxide is 1 to 40 weight parts; and a doping element of the doped tin oxide includes niobium, and the doped tin oxide has a coordinate L* value of 70 to 100, a coordinate a value of -5 to 5, and a coordinate b value of -5 to 5 in a CIELab color space.

In some embodiments, based on 100 weight parts of the polymer, the content of the doped tin oxide is 1 to 5 weight parts.

In some embodiments, the doped tin oxide has a reflectivity of no more than 60 % to a light with a wavelength of 1064 nm.

In some embodiments, the doped tin oxide has a coordinate L* value of 80 to 90, a coordinate a value of -5 to 2, and a coordinate b value of 2 to 4 in a CIELab color space.

In some embodiments, based on the total weight of the doped tin oxide, the content of the tin oxide is 70 wt% to 99.9 wt%, and the content of the niobium is 0.1 wt% to 30 wt% calculated as Nb₂O₅.

Embodiments of a third aspect of the present disclosure provide a polymer molded body, at least a part of a surface of the polymer molded body being formed by the polymer composition mentioned above.

In some embodiments, the polymer molded body is substantially formed by the polymer composition mentioned above.

Embodiments not falling under the claimed invention further refer to an ink composition. The ink composition includes a binder; and a doped tin oxide, wherein a doping element of the doped tin oxide includes niobium, and the doped tin oxide has a coordinate L* value of 70 to 100, a coordinate a value of -5 to 5, and a coordinate b value of -5 to 5 in a CIELab color space.

In some embodiments, based on 100 weight parts of the doped tin oxide, the amount of the binder is 1 to 60 weight parts.

In some embodiments, the binder includes at least one selected from a group consisting of cellulose acetate, polyacrylate resin, ethylene-vinyl acetate copolymer, polyvinyl alcohol, polyvinyl acetal, polyvinyl acetate, polyvinyl pyrrolidone and poly phosphonic acid.

In some embodiments, the doped tin oxide has a reflectivity of no more than 60 % to a light with a wavelength of 1064 nm.

In some embodiments, the doped tin oxide has a coordinate L* value of 80 to 90, a coordinate a value of -5 to 2, and a coordinate b value of 2 to 4 in a CIELab color space.

In some embodiments, based on the total weight of the doped tin oxide, the content of the tin oxide is 70 wt% to 99.9 wt%, and the content of the niobium is 0.1 wt% to 30 wt% calculated as Nb₂O₅.

Using a doped tin oxide containing niobium as doping element as a chemical plating promoter in a method for selectively metallizing a surface of an insulating substrate, the doped tin oxide with light color present in the insulating substrate such as plastic, having a coordinate L* value of 70 to 100, a coordinate a value of -5 to 5, and a coordinate b value of -5 to 5 in a CIELab color space, will not or substantially will not significantly interfere the color of the insulating substrate.

Additionally, the doped tin oxide mentioned in the present disclosure has a strong ability to promote chemical plating without reducing the metal element thereof to pure metal, i.e. the doped tin oxide may be used as a chemical plating promoter with a flexible usage scope. The doped tin oxide may not only be present in an insulating substrate such as polymer, and may also be directly coated or printed on a surface of the substrate as an ink layer. More importantly, when using the doped tin oxide as a chemical plating promoter, a higher plating speed may be obtained and a continuous metal layer may be formed with a higher adhesion layer between the metal layer and the insulating substrate, and both the production efficiency and the quality of the plating parts may be improved.

Additional aspects and advantages of the embodiments of the present disclosure will be given in part in the following descriptions, become apparent in part from the following descriptions, or be learned from the practice of the embodiments of the present disclosure.

### DETAILED DESCRIPTION

Reference will be made in detail to embodiments of the present disclosure. The embodiments described herein with reference to the accompany drawings are explanatory and illustrative, which are used to generally understand the present disclosure. The embodiments shall not be construed to limit the present disclosure.

For the purpose of the present description and of the following claims, the definitions of the numerical ranges always include the extremes unless otherwise specified.

In addition, terms such as "first" and "second" are used herein for purposes of description and are not intended to indicate or imply relative importance or significance.

According to a first aspect of embodiments of the present disclosure, use of a doped tin oxide as a chemical plating promoter in selectively metallizing a surface of an insulating substrate is provided.

The term of "chemical plating promoter" used herein is intended to mean a material which may promote a substrate without original ability to be chemically plated to realize a chemical plating and obtain a continuous metal layer formed on the surface thereof.

According to the present disclosure, the doped tin oxide includes niobium as doping element thereof. In some embodiments, based on the total weight of the doped tin oxide, the content of the tin oxide is 70 wt% to 99.9 wt%. In some embodiments, based on the total weight of the doped tin oxide, the content of the tin oxide is 90 wt% to 96 wt%. In some embodiments, based on the total weight of the doped tin oxide, the content of the niobium is 0.1 wt% to 30 wt% calculated as Nb₂O₅. In some embodiments, based on the total weight of the doped tin oxide, the content of the niobium is 1 wt% to 20 wt% calculated as Nb₂O₅. In some embodiments, based on the total weight of the doped tin oxide, the content of the niobium is 4 wt% to 10 wt% calculated as Nb₂O₅. The composition of the doped tin oxide can be determined by any conventional analysis and test methods, for example, it can be tested by inductively coupled plasma-atomic emission spectrometry (ICP-AES), or determined by the amount of raw materials used in a preparation process thereof.

In some embodiments, the doped tin oxide may have an average particle size of 10 nm to 10 µm. In some embodiments, the doped tin oxide may have an average particle size of 50 nm to 5 µm. In some embodiments, the doped tin oxide may have an average particle size of 80 nm to 2.5 µm. In some embodiments, the particle size of the doped tin oxide may be selected properly according to practical requirements. For example, when presetting it in the substrate such as polymer, the average particle size of the doped tin oxide may be preferably 100 nm to 10 µm, more preferably 500 nm to 2.5 µm, and when using the doped tin oxide for preparing an ink composition, the average particle size of the doped tin oxide may be preferably 1 nm to 800 nm, more preferably 10 nm to 500 nm. The average particle size may be determined by any conventional method which is known to those skilled in the art, for example, measured by a laser particle analyzer. According to the present disclosure, the definitions of the numerical ranges always include the endpoint value thereof unless otherwise specified.

The doped tin oxide according to embodiments of the present disclosure has a light color, and has a CIELab color value L* of 70 to 100, a CIELab color value a of -5 to 5, and a CIELab color value b of -5 to 5, in other words, the doped tin oxide may have a coordinate L* value of 70 to 100, a coordinate a value of -5 to 5, and a coordinate b value of -5 to 5 in a CIELab color space.

In some embodiments, the dope tin oxide has the CIELab color value L* is 80 to 90, the CIELab color value a is -5 to 2, and the CIELab color value b is 2 to 4, in other words, the doped tin oxide may have a coordinate L* value of 80 to 90, a coordinate a value of -5 to 2, and a coordinate b value of 2 to 4 in a CIELab color space. The doped tin oxide with above mentioned CIELab color value ranges, may show both a light color and a good ability of promoting chemical plating, and can form a metal layer on the substrate with high adhesion force at high plating speed during the chemical plating process.

The doped tin oxide may have a high absorption power to light, and shows a light reflectivity of no more than 60 % at a wavelength of 1064nm, and even no more than 40 %, for example, 20 % to 30 %. In other words, the doped tin oxide has a reflectivity of no more than 60 % to a light with a wavelength of 1064 nm. According to the present disclosure, the light reflectivity of the doped tin oxide may be tested by a traditional method, an example thereof is described in GJB 5023.1-2003.

In some embodiments, the doped tin oxide may be prepared by steps of: providing a powder mixture including a tin oxide and at least one compound containing a doping element including niobium; then sintering the powder mixture in an oxidizing atmosphere. The obtained compound includes at least one of an oxide of the doping element and a precursor capable of forming the oxide of the doping element through sintering. The oxide of the doping element, such as the oxide of niobium, may choose Ni₂O₅. And the precursor used to form the oxide of the doping element under the sintering may be any compounds capable forming the oxide of the doping element, such as hydroxides (e.g. niobium hydroxide) and/or a gel (e.g. niobium-containing gel). While the powder mixture is prepared by methods of semi-dry grinding or wet grinding as described below, the precursor may be a compound insoluble in the dispersant used in the methods of the semi-dry grinding or wet grinding.

The contents of the tin oxide and the compound in the powder mixture can be selected according to the desired doping element content in the doped tin oxide. Usually, the composition of the powder mixture may be adjusted to produce the following contents: the content of the tin oxide is 70 wt% to 99.9 wt%, preferably 90 wt% to 96 wt%; and the content of the niobium is 0.1 wt% to 30 wt% calculated as Nb₂O₅, preferably 1 wt% to 20 wt%, more preferably 4 wt% to 10 wt%, based on the total weight of the doped tin oxide intended.

There is no special limiting to the method for preparing the powder mixture, which may be a selected by the person skilled in the art depending on actual practice. In some embodiments, the powders may be obtained by grinding the tin oxide and the metal compound containing the doping element. The grinding may be performed by a dry grinding process, a wet grinding process, or a semi-dry grinding process. In some embodiments, the semi-dry grinding process and the wet grinding process may be carried out using a dispersant. The dispersant may be any normally used dispersant in a conventional grinding process. In some embodiments, the dispersant may be water and/or C₁-C₅ alcohol, for example, ethanol. The content of the dispersant may be any known in the art without special limiting. In some embodiments, the powders may be obtained by a wet grinding process or a semi-dry grinding process. And the wet grinding process and the semi-dry grinding process may further include a drying step. The drying may be carried out by a normal drying process. In some embodiments, the drying is carried out at a temperature ranging from 40 °C to 120 °C. In some embodiments, the drying may be carried out under an atmosphere containing oxygen, or under a non-reactive atmosphere. The atmosphere containing oxygen may be air or a combination of oxygen and a non-reactive gas. The non-reactive gas may refer to any gas which may not react chemically with the components of the powders or the prepared metal compound. For example, the non-reactive gas may be those selected from group 0 of the periodic table or nitrogen. In some embodiment, the non-reactive gas may be argon.

There is no special limiting to the size of the powder mixture in the present disclosure, which may be chosen by the person skilled in the art. In some embodiments, the powder mixture has an average particle size of 50 nm to 10 µm. In some embodiments, the powder mixture has an average particle size of 500 nm to 5µm.

In some embodiments, the sintering may be conducted at a temperature ranging from 500 °C to 1800 °C. In some embodiments, the sintering may be conducted at a temperature ranging from 600 °C to 1500 °C. In some embodiments, the sintering may be conducted at a temperature not higher than 1300 °C, thus obtained doped tin oxide has a light color similar to the powder mixture, i.e. raw materials. From the viewpoint of further improving the promoting power of the doped tin oxide, the sintering may be conducted preferably at a temperature of higher than 800 °C, more preferably higher than 1000 °C. When the sintering temperature is 1000 °C to 1300 °C, the obtained doped tin oxide has a light color similar to the powder mixture, and shows a good ability of promoting chemical plating. The condition for sintering may be selected according to the sintering temperature, and the sintering may be performed for a time period ranging from 1 hour to 30 hours, preferably 4 hours to 10 hours.

In some embodiments, the sintering may be carried out under an oxidizing atmosphere. The oxidizing atmosphere is generally an atmosphere containing oxygen. Thus, for example, the atmosphere containing oxygen may be pure oxygen atmosphere. And, the atmosphere containing oxygen may also be a combination of oxygen and a non-reactive gas. The non-reactive gas may refer to any gas which may not react chemically with the raw materials and the products of the sintering process. For example, the non-reactive gas may be those selected from group 0 of the periodic table or nitrogen. In some embodiment, in an oxidizing atmosphere containing oxygen and non-reactive gas, the volume amount of oxygen is preferably more than 70 vol%, then the atmosphere containing oxygen may be air.

In some embodiments, the method further includes a step of grinding a solid product obtained from the sintering step in order to provide the final product with more demanding properties. In some embodiments, the particle size of a grinded product obtained from the grinding step may have an average particle size ranging from 10 nm to 10 µm. In some embodiments, the grinded product may have an average particle size ranging from 50 nm to 5 µm. In some embodiments, the grinded product may have an average particle size ranging from 80 nm to 2.5 µm. The further grinding may be performed by at least one process selected from a group including: dry grinding process, wet grinding process and semi-dry grinding process, which are known in the art and have been described in the above. In some embodiments, the semi-dry grinding process and the wet grinding process may be carried out using a dispersant. The dispersant may be any normally used dispersant in a conventional grinding process. In some embodiments, the dispersant may be water and/or C₁-C₅ alcohol, for example, ethanol. The content of the dispersant is known in the art, without special limiting.

In some embodiments, the application mode of the doped tin oxide used as a chemical plating promoter in a method for selectively metallizing a surface of an insulating substrate can be selected according to the particular application situation. Hereinafter two example embodiments are provided and it would be appreciated by those skilled in the art that the method mode of the doped tin oxide enumerated below cannot be limited to these two embodiments.

In one embodiment, the doped tin oxide may be dispersed in an insulating substrate (such as a polymer substrate), and with an energy beam irradiation to expose the doped tin oxide, then electroless plating is carried out. In another embodiment, the doped tin oxide may be coated on the insulating substrate surface as an ink layer, followed by electroless plating.

According to a second aspect of the present disclosure, a polymer composition is provided. The polymer composition includes a polymer and the doped tin oxide mentioned above. The doped tin oxide and its preparation may be the same as what described above.

In some embodiments, based on 100 weight parts of the polymer, the content of the doped tin oxide is 1 to 40 weight parts. In some embodiments, based on 100 weight parts of the polymer, the content of the doped tin oxide is 1 to 30 weight parts. In some embodiments, based on 100 weight parts of the polymer, the content of the doped tin oxide is 1 to 20 weight parts. In some embodiments, based on 100 weight parts of the polymer, the content of the doped tin oxide is 1 to 10 weight parts. With the strong ability of the doped tin oxide mentioned above to promote chemical plating, even at a lower content, such as based on 100 weight parts of the polymer, the content of the doped tin oxide may be 1 to 5 weight parts, or even 1 to 3weight parts, the polymer molded body formed by the polymer composition is still capable of electroless plating after the energy beam irradiation for peeling the polymer, and can obtain a higher plating speed, forming a complete continuous metal layer with a high adhesion to the substrate. In addition, the polymer molded body may also have excellent mechanical properties.

There is no special limiting to the type of the polymer in the polymer composition, and it may be selected according to practical requirements. In some embodiments, the polymer may be a thermoplastic polymer or a thermosetting polymer. In an embodiment, the base polymer may be at least one selected from a group including: plastic, rubber and fiber. By way of example and without limits, in some embodiments the polymer may be at least one selected from a group including: polyolefin, such as polystyrene, polypropylene, poly(methyl methacrylate) and poly(acrylonitrile-butadiene-styrene); polycarbonate; polyester, such as poly(cyclohexylene dimethylene terephthalate), poly(diallyl isophthalate), poly(diallyl terephthalate), poly(butylene naphthalate), poly(ethylene terephthalate) and poly(butylene terephthalate); polyamide, such as poly(hexamethylene adipamide), poly(hexamethylene azelamide), poly(hexamethylene succinamide), poly(hexamethylene lauramide), poly(hexamethylene sebacamide), poly(decamethylene sebacamide), polyundecanamide, poly(lauramide), poly(octanamide), poly(9-amino nonanoic acid), polycaprolactam, poly(phenylene terephthalamide), poly(hexylene isophthalamide), polyhexamethylene terephthalamide and poly(nonylene terephthalamide); poly(aromatic ether); polyether imide; polycarbonate/(acrylonitrile-butadiene-styrene) alloy; polyphenylene oxide; polyphenylene sulfide; polyimide; polysulfone; poly(ether-ether-ketone); polybenzimidazole; phenol formaldehyde resin; urea formaldehyde resin; melamine-formaldehyde resin; epoxide resin; alkyd resin; and polyurethane.

In some embodiments, the polymer composition may further contain at least one additive. In some embodiments, the additive may be, for example, filler, antioxidant, light stabilizer and lubricant and so on. By the addition of the additive, the performance and property of the polymer molded body may be improved, and the processing performance of the polymer composition may be improved. There is no special limiting to the content and the type of the additive, provided the colour of the additive is light. The additive may be selected according to, for example, practical requirements.

The filler used as the additive to the polymer composition may be any filler which is non-reactive under the effect of laser (either physically or chemically). In some embodiments, the filler may be at least one selected from talc and/or calcium carbonate.

In some embodiments, the filler may be glass fiber. With the addition of glass fiber, the thickness of the removed substrate (in other words, the distance from the top surface of the polymer molded body to the exposed doped tin oxide) may be significantly increased, which may facilitate the deposition of metal onto the doped tin oxide during the following chemical plating process.

The filler may be any conventional inorganic filler which may act with the effect of the energy source, such as the laser. In some embodiments, the filler may also be selected from micro glass bead, calcium sulfate, barium sulfate, titanium dioxide, pearl powder, wollastonite, diatomite, caoline, coal fines, pot clay, mica, oil shale ash, aluminum silicate, alumina, silica, talc and zinc oxide.

The antioxidant used as the additive to the polymer molded body formed by the polymer composition may be any conventional antioxidant in the related art. In some embodiments, the antioxidant may contain a primary antioxidant and a secondary antioxidant. The ratio between the primary antioxidant and the secondary antioxidant may be appropriately selected according to, for example, the type of the antioxidant. In some embodiments, the weight ratio between the primary antioxidant and the secondary antioxidant may be 1:1-4.

In some embodiments, the primary antioxidant may be a hindered phenol antioxidant. By way of example but without limits, in some embodiments, the primary antioxidant may be antioxidant 1098 or antioxidant 1010, in which the antioxidant 1098 mainly contains N,N'-bis-(3-(3,5-di-tert-butyl-4-hydroxyphenyl)propionyl)hexane diamine and the antioxidant 1010 mainly contains tetra[3-(3,5-di-tert-butyl-4-hydroxyphenyl)propionic acid]pentaerythritol.

In some embodiments, the secondary antioxidant may be a phosphite ester antioxidant. By way of example and without limits, in some embodiments, the secondary antioxidant may be antioxidant 168, which mainly contains tri(2,4-di-tert-butyl-phenyl)phosphorite.

In some embodiments, the light stabilizer used as the additive to the polymer article may be of the hindered amine type. In some embodiments, the light stabilizer may be bis(2,2,6,6-tetramethyl-4-piperidyl)sebacate. The light stabilizer may be any known ones in the art, without special limiting in the present disclosure.

In some embodiments, the lubricant may be at least one selected from a group including: ethylene/vinyl acetate copolymer (EVA wax), polyethylene (PE wax) and stearate. With the addition of the lubricant, the flowing performance of the polymer molded body may be improved.

In some embodiments, the content of the additive may be appropriately selected according to functions and types of the additives. In some embodiments, based on 100 weight parts of the polymer composition, the content of the filler may range from 1 weight part to 40 weight parts, the content of the antioxidant may range from 0.1 weight parts to 10 weight parts, the content of the light stabilizer may range from 0.1 weight parts to 10 weight parts, and the content of the lubricant may range from 0.1 weight parts to 10 weight parts.

According to a third aspect of the present disclosure, a polymer molded body is provided. At least a part of a surface of the polymer molded body is formed by the polymer composition mentioned above.

According to the present disclosure, the surface of the polymer body refers to all exposed surface, including not only the outer surface, such as above, bottom, side, front, rear, left and right surface, further including an inner surface of molded body formed by machining, for example: the inner surface of a hole drilled in the molded body.

The doped tin oxide in the polymer composition used to form the polymer molded body has a light color, and has an ability to promote chemical plating. So the surface of the polymer molded body required to form a metal layer via chemical plating is formed by the polymer composition, thus the surface formed by above polymer composition can form a metal layer pattern via chemical plating after the energy beam irradiation for peeling the polymer.

In some embodiments, only a part of a surface of the polymer molded body may be formed by the polymer composition, or the whole polymer molded body may be formed by the polymer composition mentioned above, i.e., the polymer molded body is formed by the polymer composition. From the viewpoint of cost reduction, only a surface or a part of a surface of the polymer molded body may be formed by the polymer composition while the thickness thereof is very large; and the polymer molded body may be integrally formed by the polymer composition while the thickness is not very large.

The size of the polymer molded body may be selected properly according to intended use of the case, without special limiting in the present disclosure. The polymer molded body can be any shape according to practical use.

In some embodiments, the molding step may be performed by any conventional molding process known in the art, without special limiting in the present disclosure. In some embodiments, the molding step is performed by injection molding. In another embodiment, the molding step is performed by extrusion molding.

According to a fourth aspect of the present disclosure, use of the polymer composition or the polymer molded body mentioned above is provided, with the polymer composition or the polymer molded body being used in a method for selectively metallizing a surface of a polymer substrate.

In one embodiment, the polymer composition is used to form a polymeric substrate or a surface of the polymer substrate, or the polymer molded body is used as the polymer substrate; then chemical plating is carried out after gasifying a part of a surface of the polymer substrate by irradiating the surface with an energy source, thereby achieve selective metallization on the surface of the polymer substrate.

In some embodiments, the energy source may be at least one selected from a group including: laser, electron beam and ion beam. In an embodiment, the energy source is a laser. The energy provided by the laser must ensure the polymer substrate in the irradiated area of the surface thereof gasified and the doped tin oxide in the irradiated area is exposed.

In some embodiments, the irradiating step may be performed by using a laser, and the laser may have a wavelength of 157-10600 nm and a power of 1-100 W.

The doped tin oxide has excellent absorption capability to energy provided by the energy source, thus the polymer substrate in the predetermined part may be removed and the doped tin oxide in the predetermined part may be exposed, even irradiating with the energy source which provides relatively lower energy. In an embodiment, the laser may have a wavelength of 1064-10600 nm and a power of 3-50 W. In another embodiment, the laser may have a wavelength of 1064 nm and a power of 3-40 W. In a further embodiment, the laser may have a wavelength of 1064 nm and a power of 5-10 W. The predetermined part of the surface of the polymer substrate may form a pattern, then the metal layer formed on the predetermined part may form a metal pattern on the polymer substrate. With the laser, the precision of the metal pattern may be improved.

In some embodiments, the irradiating step may be performed by using an electron beam, and the electron beam may have a power density of 10-10¹¹ W/cm².

In some embodiments, the irradiating step may be performed by using an ion beam, and the ion beam may have an energy of 10-10⁶ eV.

The chemical plating is well known to person having ordinary skill in the art. In some embodiments, the chemical plating may be carried out with the following steps. The polymer substrate subjected to the irradiating is immersed in a Cu solution. In some embodiments, the Cu solution may contain a Cu salt. In some embodiments, the Cu solution may further contain a reducing agent. In some embodiments, the Cu solution may have a pH ranging from 12 to 13. In some embodiments, the reducing agent may reduce the Cu ions in the Cu salt into Cu metal. In some embodiments, the reducing agent may be at least one selected from a group including: glyoxylic acid, diamide, and sodium phosphorate.

The thickness of the metal layer formed by chemical plating may be selected by practical requirements, without special limiting. In some embodiments, the thickness of the metal layer is 0.1 µm to 10 µm.

In some embodiments, the shape of the metal layer may be selected by practical requirements. For example, if the polymer article obtained after the chemical plating is used to prepare a circuit board, the metal layer may be a metal layer pattern.

In some embodiments, the method may further include a step of electroplating or chemical plating. The electroplating or chemical plating may be performed for at least one time, so that additional metal layers, either of the same metal as or of different metals from the prior metal layers, may be formed on the prior metal layers. In some embodiments, a Cu layer is formed on the surface of the polymer substrate in the first chemical plating step, then a Ni layer is formed on the Cu layer in the following electroplating or chemical plating. With the additional Ni layer, oxidation of the Cu layer may be prevented.

According to a fifth aspect of embodiments of the present disclosure, an ink composition is provided. The ink composition includes a binder and the doped tin oxide mentioned above. And the doped tin oxide contains niobium as its doping element, and has a CIELab color value L* of 70 to 100, a CIELab color value a of -5 to 5, and a CIELab color value b of -5 to 5. The doped tin oxide has an average particle size of 1 nm to 800 nm, preferably 10 nm to 500 nm, more preferably 50 nm to 300 nm.

According to embodiments of the present disclosure, when the ink composition is applied on a surface of an insulating substrate, the binder may contribute to the uniform dispersion of the doped tin oxide on the surface of the insulating substrate. In some embodiments, with the binder, an ink, layer which may contain the binder and the ink composition, may be formed on the surface of the insulating substrate. In some embodiments, the ink layer with the binder material can have certain required strength which allows strong adhesion between the ink layer and the insulating substrate.

There is no special limiting to the binder, provided the above requirements are satisfied. In some embodiments, the binder is an organic binder. In some embodiments, the binder may be at least one selected from a group including: cellulose acetate, polyacrylate resin, ethylene-vinyl acetate copolymer (referred EVA binder), polyvinyl alcohol, polyvinyl acetal, polyvinyl acetate, polyvinyl pyrrolidone, polyphosphonic acid.

There is no special limiting to the binder in the present disclosure. In some embodiments, a commercially available binder may be used. In some embodiments, the binder is at least one selected from a group including: butyl acetate cellulose of CAB series commercially available from Eastman Chemical Company, US, such as butyl acetate cellulose No. CAB381-0.5, butyl acetate cellulose No. CAB381-20, butyl acetate cellulose No. CAB551-0.2 and butyl acetate cellulose No. CAB381-2; and polyvinyl butyral of Mowital series commercially from Kuraray Company, JP, such as polyvinyl butyral No. Mowital B 60T, polyvinyl butyral No. Mowital B 75H and polyvinyl butyral No. Mowital B 60H.

There is no special limiting to the ratio between the binder and the doped tin oxide in the ink composition, provided the doped tin oxide may be dispersed uniformly on the surface of the insulating substrate. In some embodiments, the ink layer has certain amount of strength and certain amount of adhesion with the insulating substrate, wherein, at least one metal layer may be formed on the ink layer. In some embodiments, based on 100 weight parts of the doped tin oxide, the amount of the binder may range from 1 weight part to 60 weight parts. In some embodiments, the amount of the binder may range from 30 weight parts to 60 weight parts.

In some embodiments, the ink composition may further contain a solvent. With the solvent, the doped tin oxide may be dispersed in the binder more uniformly, and a more uniform ink layer may be formed on the surface of the insulating substrate.

The solvent may be any conventional one known to those with ordinary skill in the art, without specific limits. In some embodiments, the solvent may be at least one selected from a group including: water, C₁-C₁₂ alcohol, C₃-C₁₂ ketone, C₆-C₁₂ aromatic hydrocarbon, C₁-C₁₂ alkyl halide, and C₂-C₁₂ alkenyl halide.

In some embodiments, the solvent may be at least one selected from a group including: methanol, ethanol, n-propanol, iso-propanol, n-butanol, tert-butanol, n-pentanol, n-hexanol, n-heptanol, n-octanol, acetone, 2-n-pentanone, 2-n-butanone, 3-methyl-2-pentanone, 2,3-butanedione, 2,3-pentanedione, 2,5-hexanedione, 1,3-cyclohexanedione, toluene, xylene and trichloroethylene.

There is no special limiting to the content of solvent in the ink composition. In some embodiments, a content of solvent is added to disperse the doped tin oxide uniformly in the binder and to form a uniform ink layer on the surface of the insulating substrate. In some embodiments, based on 100 weight parts of the doped tin oxide, the content of the solvent may range from 20 weight parts to 250 weight parts.

In some embodiments, the ink composition may further contain an additive. The additive may be selected according to, for example, its specific performance or functions. In some embodiments, the additive may be at least one selected from a group including: dispersant, antifoaming agent, leveling agent and viscosity regulator.

The content of the additive may be selected according to, for example, conventional operations. In some embodiments, based on 100 weight parts of the doped tin oxide, the amount of the additive may range from 0.1 weigh parts to 20 weight parts. In some embodiments, the amount of the additive may range from 0.5 weigh parts to 10 weight parts.

According to some embodiments of the present disclosure, with the dispersant, the time which the doped tin oxide costs to disperse uniformly in the binder and the optional solvent may be reduced, and the stability of the doped tin oxide may be improved. The dispersant may be any substance which is capable of providing the above functions, without specific limits. In some embodiments, the dispersant may be an organic dispersant.

In some embodiments, the organic dispersant may be at least one selected from a group including: aliphatic amine type dispersant, hydramine type dispersant, cyclic unsaturated amine type dispersant, fatty acid type dispersant, aliphatic amide type dispersant, ester type dispersant, paraffin type dispersant, phosphate type dispersant, polymer type dispersant (such as polyacrylate type dispersant or polyester type dispersant) and organic phosphine type dispersant.

In some embodiments, the dispersant may be any conventional one that is commercially available. In some embodiments, the dispersant may be at least one selected from a group including: dispersants with the following Nos. commercially available from BYK company, GE: ANTI-TERRA-U, ANTI-TERRA-U 80, ANTI-TERRA-U 100, DISPERBYK-101, DISPERBYK-130, BYK-220 S, LACTIMON, LACTIMON-WS, BYK-W 966, DISPERBYK, BYK-154, BYK-9076, DISPERBYK-108, DISPERBYK-109, DISPERBYK-110, DISPERBYK-102, DISPERBYK-111, DISPERBYK-180, DISPERBYK-106, DISPERBYK-187, DISPERBYK-181, DISPERBYK-140, DISPERBYK-142, DISPERBYK-145, DISPERBYK-115, DISPERBYK-160, DISPERBYK-161, DISPERBYK-162, DISPERBYK-163, DISPERBYK-164, DISPERBYK-165, DISPERBYK-166, DISPERBYK-167, DISPERBYK-182, DISPERBYK-183, DISPERBYK-184, DISPERBYK-185, DISPERBYK-168, DISPERBYK-169, DISPERBYK-170, DISPERBYK-171, DISPERBYK-174, DISPERBYK-190, DISPERBYK-2150, BYK-9077, DISPERBYK-112, DISPERBYK-116, DISPERBYK-191, DISPERBYK-192, DISPERBYK-2000, DISPERBYK-2001, DISPERBYK-2010, DISPERBYK-2020, DISPERBYK-2025, DISPERBYK-2050 and DISPERBYK-2070; dispersant No. PHOSPHOLAN PS-236 commercially available from Akzo Nobel Company, DL; dispersant No. PS-21A commercially available from Witco Chemical Company, US; and dispersants Serial Nos. Hypermer KD and Zephrym PD commercially available from Croda Company, GB.

The content of the dispersant may be determined based on actual practice without specific limiting. In some embodiments, based on 100 weight parts of the doped tin oxide, the content of the dispersant may range from 0.1 weight parts to 4 weight parts.

The antifoaming agent may be any conventional one capable of preventing the formation of foams, destroying the formed foams or removing the formed foams from the ink composition. In some embodiments, the antifoaming agent may be at least one selected from a group including: organic polysiloxane type antifoaming agent, polyether type antifoaming agent and fatty alcohol type antifoaming agent. In some embodiments, the antifoaming agent is of the organic polysiloxane series.

The antifoaming agent may be any conventional one which is commercially available. In some embodiments, the antifoaming agent may be at least one selected from a group including: antifoaming agents having the following Nos. commercially available from BYK Comapnay, GE: BYK-051, BYK-052, BYK-053, BYK-055, BYK-057, BYK-020, BYK-065, BYK-066N, BYK-067A, BYK-070, BYK-080A, BYK-088, BYK-141, BYK-019, BYK-021, BYK-022, BYK-023, BYK-024, BYK-025, BYK-028, BYK-011, BYK-031, BYK-032, BYK-033, BYK-034, BYK-035, BYK-036, BYK-037, BYK-038, BYK-045, BYK-A530, BYK-A555, BYK-071, BYK-060, BYK-018, BYK-044 and BYK-094.

The content of the antifoaming agent in the ink composition is known to a person having ordinary skill in the related art, without specific limits. In some embodiments, based on 100 weight parts of the doped tin oxide, the content of the antifoaming agent may range from 0.01 weight parts to 3 weight parts.

According to embodiments of the present disclosure, with the addition of a leveling agent, the ink layer formed on the surface of the insulating substrate can be more flat and become smoother. There is no special limiting to the leveling agent in the present disclosure, and the leveling agent may be conventional ones which are capable of realizing the above functions. In some embodiments, the leveling agent may be at least one selected from a group including: polyacrylate series, polydimethylsiloxane series, polymethylphenylsiloxane series and fluorine-containing surfactant.

The leveling agent may be any conventional one which is commercially available. In some embodiments, the leveling agent may be at least one selected from a group including: leveling agents having the following Nos. commercially available from BYK Company, GE: BYK-333, BYK-306, BYK-358N, BYK-310, BYK-354 and BYK-356.

The content of the leveling agent in the ink composition is known to a person having ordinary skill in the related art, without specific limits. In some embodiments, based on 100 weight parts of the doped tin oxide, the content of the leveling agent may range from 0.3 weight parts to 4 weight parts.

According to embodiments of the present disclosure, with the addition of a viscosity regulator, the viscosity of the ink composition may be adjusted, depending on the practical requirements. There is no special limiting to the viscosity regulator in the present disclosure, and the viscosity regulator may be conventional ones. In some embodiments, the viscosity regulator may be at least one selected from a group including: gaseous silica, polyamide wax, organic bentonite, hydrogenated castor oil, metallic soap, hydroxyl alkyl cellulose and derivatives thereof; polyvinyl alcohol and polyacrylate.

The content of the viscosity regulator in the ink composition is well known to a person having ordinary skill in the related art, without specific limits. In some embodiments, based on 100 weight parts of the doped tin oxide, the content of the viscosity regulator may range from 0.3 weight parts to 3 weight parts.

In some embodiments, the ink composition contains, or alternatively consists of, the doped tin oxide, the binder, the solvent, the dispersant, the antifoaming agent, the leveling agent and the viscosity regulator. Based on 100 weight parts of the doped tin oxide, the amount of the binder ranges from 1 weight part to 60 weight parts. In some embodiments, the amount of the solvent ranges from 20 weight parts to 250 weight parts. In some embodiments, the amount of the dispersant ranges from 0.4 weight parts to 4 weight parts. In some embodiments, the amount of the antifoaming agent ranges from 0.1 weight part to 3 weight parts. In some embodiments, the amount of the leveling agent ranges from 0.3 weight parts to 4 weight parts. In some embodiments, the amount of the viscosity regulator ranges from 0.3 weight parts to 3 weight parts.

There is no special limiting to the preparing method of the ink composition in the present disclosure, provided the doped tin oxide, the binder and the optional additive are mixed uniformly. In some embodiments, the method for preparing the ink composition includes the following steps. The doped tin oxide, the binder and the optional solvent and additive are mixed to form a first mixture. Then the first mixture is grinded in a mixer which can be, for example, a planetary ball mill, to obtain the ink composition. Mixing and grinding in the planetary ball mill, as well as operation steps and conditions for the mixing and grinding, are well known to a person having ordinary skill in the art, thus details thereof are omitted.

According to embodiments of the present disclosure, by applying the ink composition on the surface of the insulating substrate, which can be non-conductive to, for example, electricity, and followed by chemical plating on the insulating substrate, selective metallization of the surface of the insulating substrate may be achieved. In some embodiments, when applying the ink composition on the surface of the insulating substrate to form the ink layer, the doped tin oxide is dispersed in a predetermined part of the ink layer, or on a predetermined part of the surface of the insulating substrate. Then with the following chemical plating, metals may be deposited on the predetermined part of the insulating substrate, thereby at least one metal layer may be formed on the predetermined part of the insulating substrate. In this way, the selective metallization of the surface of the insulating substrate can be achieved.

A method for selectively metallizing a surface of an insulating substrate is provided. The ink composition is described above. The method includes forming an ink layer on the surface of an insulating substrate by providing the ink composition mentioned above on the surface of the insulating substrate, and forming at least one metal layer on the ink layer by chemical plating.

The ink composition may be applied on a predetermined part of the surface of the insulating substrate, while the remaining of the surface of the insulating substrate is not covered with the ink composition. Therefore, the ink layer is only formed in the predetermined part of the surface of the insulating substrate. As the ink layer containing the doped tin oxide is conductive, by performing the chemical plating on the insulating substrate, at least one metal layer may be formed on portion of the ink layer, for example, on the predetermined part of the surface of the insulating substrate, and the metal layer may not be deposited on the remaining area of the surface of the substrate. In this way, selective metallization of the surface of the insulating substrate can be achieved.

Various commonly used processes may be used for providing the ink composition according to embodiments of the present disclosure on the insulating substrate, for example, a process selected from a group including: screen printing, spray coating, laser printing, ink jet printing, pad printing, gravure printing, letterpress printing, and lithographic printing, can be used. Specific operating steps and conditions of screen printing, spray coating, laser printing, ink jet printing, pad printing, gravure printing, letterpress printing, and lithographic printing are well known to a person with ordinary skill in the art, so a detailed description thereof will be omitted here for the clarity purpose. In some embodiments, the ink composition is applied on the surface of the insulating substrate by ink jet printing or laser printing.

In some embodiments, the method may further include a step of drying the ink layer.

The drying is well known to a person having ordinary skill in the art, without specific limits, and the drying may be selected based on the binder material and the optional solvent in the ink composition. In some embodiments, the drying may be carried out at a temperature ranging from 40 °C to 150 °C. In some embodiments, the drying can be carried out for a time ranging from 0.5 hours to 5 hours. In some embodiments, the drying may be performed under normal pressure. In some embodiments, the drying may be performed under a decreased pressure.

There is no special limiting to the thickness of the ink layer in the present disclosure, provided that the following chemical plating is capable of perform the selective metallization on the surface of the insulating substrate. In some embodiments, the ink layer has a thickness ranging from 8 µm to 50 µm. In some embodiments, the ink layer has a thickness ranging from 12 µm to 40 µm. In some embodiments, the ink layer has a thickness ranging from 12 µm to 25 µm.

The chemical plating is well known to person having ordinary skill in the art. In some embodiments, the chemical plating may be carried out with the following steps. The insulating substrate applied with the ink layer is immersed in a Cu solution. In some embodiments, the Cu solution may contain a Cu salt. In some embodiments, the Cu solution may further contain a reducing agent. In some embodiments, the Cu solution may have a pH ranging from 12 to 13. In some embodiments, the reducing agent may reduce the Cu ions in the Cu salt into Cu metal. In some embodiments, the reducing agent may be at least one selected from a group including: glyoxylic acid, diamide, and sodium phosphorate.

In some embodiments, the method may further include a step of electroplating or chemical plating. The electroplating or chemical plating may be performed for at least one time, so that additional metal layers, either of the same metal as or of different metals from the prior metal layers, may be formed on the prior metal layers. In some embodiments, a Cu layer is formed on the surface of the insulating substrate in the first chemical plating step, then a Ni layer is formed on the Cu layer in the following electroplating or chemical plating. With the additional Ni layer, oxidation of the Cu layer may be prevented.

In some embodiments, the method further includes gasifying at least a part of a surface of the ink layer by irradiating the surface of the ink layer with an energy source, before the step of chemical plating. With the irradiating step, a predetermined part of the ink layer may be removed and the doped tin oxide of the ink composition in this part may be exposed. Then the metal layer may be formed on the predetermined part in the following plating step. By subjecting the ink layer applied on the surface of the insulating substrate to irradiation, the metal layer formed in the subsequent chemical plating step may have a better adhesion to the insulating substrate.

In some embodiments, the energy source may be at least one selected from a group including: laser, electron beam and ion beam. In an embodiment, the energy source is a laser. The energy provided by the laser must ensure the base polymer in the irradiated area of the surface of the polymer article is gasified and the doped tin oxide in the irradiated area is exposed. The doped tin oxide has excellent absorption capability to energy provided by the energy source, thus the base polymer in the predetermined part may be removed and the doped tin oxide in the predetermined part may be exposed, even irradiating with the energy source which provides relatively lower energy.

In some embodiments, the irradiating may be performed by using a laser, and the laser may have a wavelength of 157-10600 nm and a power of 5-100 W. In an embodiment, the laser may have a wavelength of 1064-10600 nm and a power of 3-50 W. In another embodiment, the laser may have a wavelength of 1064 nm and a power of 3-40 W. In a further embodiment, the laser may have a wavelength of 1064 nm and a power of 5-10 W. The predetermined part of the surface of the polymer article may form a pattern, then the metal layer formed on the predetermined part may form a metal pattern on the insulating substrate. With the laser, the precision of the metal pattern may be improved.

In some embodiments, the irradiating may be performed by using an electron beam, and the electron beam may have a power density of 10-10¹¹ W/cm².

In some embodiments, the irradiating may be performed by using an ion beam, and the ion beam may have an energy of 10-10⁶ eV.

In some embodiments, the insulating substrate may contain at least one selected from a group including: plastic, rubber, fiber, coating layer, ceramic, glass, wood, cement and paper. In some embodiments, the insulating substrate may be made by plastic or ceramic.

In some embodiments, the insulating substrate is made of flexible plastic, which may include but not limited to polyethylene terephthalate, polyimide, polycarbonate, poly(ether-ketone), poly(ether-ether-ketone) and liquid crystal. When applying the flexible plastic on the surface of the insulating substrate and performing the chemical plating, the at least one metal layer formed on the insulating substrate can be used for various applications, such as preparing flexible circuits.

Some illustrative and non-limiting examples are provided hereunder for a better understanding of the present invention and for its practical embodiment.

### TEST

Samples of the doped tin oxides and the polymer molded body obtained from the following Examples and Comparative Examples were subjected to the following tests.

### Composition

In the following Examples and Comparative Examples, the composition of the doped tin oxide was measured by the amount of raw materials used for preparing thereof.

### Average particle size

In the following Examples and Comparative Examples, the average particle size of the doped tin oxide was measured by a Laser Particle Sizer commercially available from Chengdu Jingxin Powder Analyse Instrument Co., Ltd., China.

### Light reflectivity

In the following Examples and Comparative Examples, the light reflectivity of the doped tin oxide was measured by a prescribed method in GJB 5023.1-2003 via Lambda 750 UV/VIS/NIR spectrophotometer measured at a wavelength of 1064nm.

### Adhesion

In the following Examples and Comparative Examples, the adhesion between the metal layer and the polymer sheet was determined by a cross-cut process. Specifically, a surface of the sample to be measured was cut using a cross-cut knife to form 100 grids (1 mm×1 mm). A gap between adjacent grids was formed to reach the bottom of the metal layer. Debris in the test region was cleaned using a brush, and then an adhesive tape (3M600 gummed paper) was sticked to a tested grid. One end of the sticked adhesive paper was rapidly torn off in a vertical direction. Two identical tests were performed on the same grid region. The grade of the adhesion was determined according to the following standard:
Grade 5B: the cut edge is smooth and the metal layers both at the cut edge and cut intersection of the grid does not fall off;
Grade 4B: the metal layers at the cut intersection are partly removed, but no more than 5 % (area percent) of the metal layers are removed;
Grade 3B: the metal layers both at the cut edge and the cut intersection are partly removed, and 5-15 % (area percent) of the metal layers are removed;
Grade 2B: the metal layers at both the cut edge and the cut intersection are partly removed, and 15-35 % (area percent) of the metal layers are removed;
Grade 1B: the metal layers at both the cut edge and the cut intersection are partly removed, and 35-65 % (area percent) of the metal layers are removed;
Grade 0B: the metal layers at both the cut edge and the cut intersection are partly removed, and more than 65 % (area percent) of the metal layers are removed.

The results are shown in Table 1.

### Embodiment 1

The present embodiment includes the following steps.

Step 1) Particles of SnO₂ were grinded in a grinding mill for 2 h together with Nb₂O₅ and ethanol, to form a first mixture. Based on 100 weight parts of SnO₂ and Nb₂O₅, the amount of ethanol was 250 weight parts. Based on the total amount of SnO₂ and Nb₂O₅, the content of Nb₂O₅ was 10 wt%. The first mixture was dried under an air atmosphere at 60°C for 3 h, thus obtaining a second mixture having an average particle size of 1.5 µm. The second mixture was calcined under an air atmosphere at 1050°C for 5 h and grinded to powders having an average particle size of 1.2 µm. The powders included doped tin oxide, and its CIELab color value and light reflectivity are listed in Table 1.

Step 2) The powders of doped tin oxide were mixed with polyhexamethylene terephthalamide (referred PA6T) and antioxidant 1010 to form a third mixture, and then the third mixture was extruded and pelleted with an extruder to form pellets. The pellets were injection molded in an injection mould, thus forming a PA6T sheet containing the doped tin oxide. Based on 100 weight parts of the PA6T, the amount of the doped tin oxide was 5 weight parts, the amount of the antioxidant 1010 was 10 weight parts. The CIELab color value of the PA6T sheet was listed in Table 1.

Step 3) A surface of the PA6T sheet was irradiated with a laser provided by a YAG laser, to remove PA6T on a predetermined part (corresponding to the structure of a receiver) of the surface of the PA6T sheet. The laser had a wavelength of 1064 nm, a power of 5 W, a frequency of 30 kHz, a scanning speed of 1000 mm/s and a filling distance of 30 µm.

Step 4) The PA6T sheet irradiated with laser was subjected to chemical plating by using a Cu solution for 1 h, thus forming a metal layer on the predetermined part of the surface of the PA6T sheet. The metal layer may be used as an antenna. The Cu solution contained: 0.12 mol/L of CuSO₄·5H₂O, 0.14 mol/L of Na₂EDTA • 2H₂O, 10 mg/L of potassium ferrocyanide, 10 mg/L of 2,2'-bipyridine and 0.10 mol/L of glyoxylic acid. The Cu solution had a temperature of 50°C and a pH of 12.5-13 which was adjusted with NaOH and H₂SO₄.

Then the PA6Tsheet formed with the metal layer was observed, and it was found that the metal layer formed a continuous complete circuit on the PA6T sheet, without leakage of plating. The plating speed and adhesion between the metal layer and the PA6T were both listed in Table 1.

### Comparative Embodiment 1

The present embodiment includes the following steps.

Step 1) Particles of SnO₂ (raw material of step 1) in Embodiment 1) was mixed with PA6T and antioxidant 1010 to form a mixture, and then the mixture was extruded and pelleted with the same condition as described in the step 2) of Embodiment 1, thus forming a PA6T sheet containing tin oxide. Based on 100 weight parts of the PA6T, the amount of the particles of SnO₂ was 5 weight parts, the amount of the antioxidant 1010 was 10 weight parts.

Step 2) The PA6T sheet obtained from the step 1) was irradiated with a laser under the same condition as described in the step 3) of Embodiment 1.

Step 3) The PA6T sheet irradiated with laser was subjected to a chemical plating under the same condition as described in the step 4) of Embodiment 1.

It was observed that, it was not capable of forming a complete metal circuit on the PA6T sheet.

### Comparative Embodiment 2

The present embodiment includes the following steps.

Step 1) The step of preparing the doped tin oxide was substantially the same with the step 1) of Embodiment 1, with the exception that: the same amount of Sb₂O₃ was used instead of Nb₂O₅. The CIELab color value of the PA6T sheet was listed in Table 1.

Step 2) The step of preparing the PA6T sheet was substantially the same with the step 2) of Embodiment 1, with the exception that: the doped tin oxide was those obtained from thee step 1) of Comparative Embodiment 2. The CIELab color value of the PA6T sheet was listed in Table 1.

Step 3) The PA6T sheet was irradiated with a laser under the same condition as described in the step 3) of Embodiment 1.

Step 4) The PA6T sheet irradiated with laser was subjected to a chemical plating under the same condition as described in the step 4) of Embodiment 1.

It was observed that, a metal layer was formed on the PA6T sheet but with leakage of plating. The plating speed and adhesion between the metal layer and the PA6T were both listed in Table 1.

### Comparative Embodiment 3

The present embodiment includes the following steps.

Step 1) The step of preparing the doped tin oxide was substantially the same with the step 1) of Embodiment 1, with the exception that: the same amount of V₂O₅ was used instead of Nb₂O₅. The CIELab color value of the PA6T sheet was listed in Table 1.

Step 2) The step of preparing the PA6T sheet was substantially the same with the step 2) of Embodiment 1, with the exception that: the doped tin oxide was those obtained from thee step 1) of Comparative Embodiment 3. The CIELab color value of the PA6T sheet was listed in Table 1.

Step 3) The PA6T sheet was irradiated with a laser under the same condition as described in the step 3) of Embodiment 1.

Step 4) The PA6T sheet irradiated with laser was subjected to a chemical plating under the same condition as described in the step 4) of Embodiment 1.

It was observed that, a metal layer was formed on the PA6T sheet, but with leakage of plating. The plating speed and adhesion between the metal layer and the PA6T were both listed in Table 1.

### Comparative Embodiment 4

The present embodiment includes the following steps.

Step 1) The step of preparing the doped tin oxide was substantially the same with the step 1) of Embodiment 1, with the exception that: the second mixture was calcined under an nitrogen atmosphere. The CIELab color value of the PA6T sheet was listed in Table 1.

Step 2) The step of preparing the PA6T sheet was substantially the same with the step 2) of Embodiment 1, with the exception that: the doped tin oxide was those obtained from thee step 1) of Comparative Embodiment 4. The CIELab color value of the PA6T sheet was listed in Table 1.

Step 3) The PA6T sheet was irradiated with a laser under the same condition as described in the step 3) of Embodiment 1.

Step 4) The PA6T sheet irradiated with laser was subjected to a chemical plating under the same condition as described in the step 4) of Embodiment 1.

It was observed that, a complete metal circuit cannot be formed on the PA6T sheet.

### Embodiment 2

The present embodiment includes the following steps.

Step 1) The doped tin oxide was prepared by the same step 1) of Embodiment 1.

Step 2) The step of preparing the PA6T sheet was substantially the same with the step 2) of Embodiment 1, with the exception that: based on 100 weight parts of the PA6T, the amount of the doped tin oxide was 3 weight parts.

Step 3) The PA6T sheet was irradiated with a laser under the same condition as described in the step 3) of Embodiment 1.

Step 4) The PA6T sheet irradiated with laser was subjected to a chemical plating under the same condition as described in the step 4) of Embodiment 1.

It was observed that, a metal layer was formed on the PA6T sheet, without leakage of plating. The plating speed and adhesion between the metal layer and the PA6T were both listed in Table 1.

### Embodiment 3

The present embodiment includes the following steps.

Step 1) The doped tin oxide was prepared by the same step 1) of Embodiment 1.

Step 2) The step of preparing the PA6T sheet was substantially the same with the step 2) of Embodiment 1, with the exception that: based on 100 weight parts of the PA6T, the amount of the doped tin oxide was 1 weight parts.

Step 3) The PA6T sheet was irradiated with a laser under the same condition as described in the step 3) of Embodiment 1.

Step 4) The PA6T sheet irradiated with laser was subjected to a chemical plating under the same condition as described in the step 4) of Embodiment 1.

It was observed that, a metal layer was formed on the PA6T sheet, without leakage of plating. The plating speed and adhesion between the metal layer and the PA6T were both listed in Table 1.

### Embodiment 4

The present embodiment includes the following steps.

Step 1) Particles of SnO₂ were grinded in a grinding mill for 3 h together with Nb₂O₅ and ethanol, to form a first mixture. Based on 100 weight parts of SnO₂ and Nb₂O₅, the amount of ethanol was 300 weight parts. Based on the total amount of SnO₂ and Nb₂O₅, the content of Nb₂O₅ was 5 wt%. The first mixture was dried under an air atmosphere at 80 °C for 2 h, thus obtaining a second mixture having an average particle size of 2 µm. The second mixture was calcined under an air atmosphere at 1300 °C for 8 h and grinded to powders having an average particle size of 0.5 µm. The powders included doped tin oxide, and its CIELab color value and light reflectivity are listed in Table 1.

Step 2) The powders of doped tin oxide were mixed with polycarbonate (referred PC), antioxidant 1098 and talc to form a third mixture, and then the third mixture was extruded and pelleted with an extruder to form pellets. The pellets were injection molded in an injection mould, thus forming a PC sheet containing the doped tin oxide. Based on 100 weight parts of the PC, the amount of the doped tin oxide was 10 weight parts, the amount of the antioxidant 1098 was 8 weight parts, and the amount of the talc was 15 weight parts. The CIELab color value of the PC sheet was listed in Table 1.

Step 3) A surface of the PC sheet was irradiated with a laser provided by a YAG laser, to remove PC on a predetermined part (corresponding to the structure of a receiver) of the surface of the PC sheet. The laser had a wavelength of 1064 nm, a power of 4 W, a frequency of 30 kHz, a scanning speed of 1000 mm/s and a filling distance of 30 µm.

Step 4) The PC sheet irradiated with laser was subjected to a chemical plating under the same condition as described in the step 4) of Embodiment 1.

It was observed that, a metal layer was formed on the PC sheet, without leakage of plating. The plating speed and adhesion between the metal layer and the PC were both listed in Table 1.

### Embodiment 5

The present embodiment includes the following steps.

Step 1) The step of preparing the doped tin oxide was substantially the same with the step 1) of Embodiment 4, with the exception that: the second mixture was calcined under an air atmosphere at 1350 °C for 8 h .

Step 2) The step of preparing the PC sheet was substantially the same with the step 2) of Embodiment 4, with the exception that: the doped tin oxide was those obtained from the step 1) of Embodiment 5.

Step 3) The PC sheet was irradiated with a laser under the same condition as described in the step 3) of Embodiment 4.

Step 4) The PC sheet irradiated with laser was subjected to a chemical plating under the same condition as described in the step 4) of Embodiment 1.

It was observed that, a metal layer was formed on the PA6T sheet, without leakage of plating. The plating speed and adhesion between the metal layer and the PA6T were both listed in Table 1.

### Embodiment 6

The present embodiment includes the following steps.

Step 1) Particles of SnO₂ were grinded in a grinding mill for 6 h together with Nb₂O₅ and ethanol, to form a first mixture. Based on 100 weight parts of SnO₂ and Nb₂O₅, the amount of ethanol was 400 weight parts. Based on the total amount of SnO₂ and Nb₂O₅, the content of Nb₂O₅ was 4 wt%. The first mixture was dried under an air atmosphere at 50 °C for 6 h, thus obtaining a second mixture having an average particle size of 1 µm. The second mixture was calcined under an air atmosphere at 1200 °C for 8 h and grinded to powders having an average particle size of 0.8 µm. The powders included doped tin oxide, and its CIELab color value and light reflectivity are listed in Table 1.

Step 2) The powders of doped tin oxide were mixed with poly(butylene terephthalate) (referred PBT), antioxidant 1098 and talc to form a third mixture, and then the third mixture was extruded and pelleted with an extruder to form pellets. The pellets were injection molded in an injection mould, thus forming a PBT sheet containing the doped tin oxide. Based on 100 weight parts of the PBT, the amount of the doped tin oxide was 15 weight parts, the amount of the antioxidant 1098 was 8 weight parts, the amount of the talc was 20 weight parts. The CIELab color value of the PBT sheet was listed in Table 1.

Step 3) A surface of the PBT sheet was irradiated with a laser provided by a YAG laser, to remove PBT on a predetermined part (corresponding to the structure of a receiver) of the surface of the PC sheet. The laser had a wavelength of 1064 nm, a power of 6 W, a frequency of 30 kHz, a scanning speed of 1000 mm/s and a filling distance of 30 µm.

Step 4) The PBT sheet irradiated with laser was subjected to a chemical plating under the same condition as described in the step 4) of Embodiment 1.

It was observed that, a metal layer was formed on the PBT sheet, without leakage of plating. The plating speed and adhesion between the metal layer and the PBT were both listed in Table 1.

**Table 1**

| | Doped tin oxide | | | | Polymer sheet | | | Plating speed (µm/h) | Adhesion |
|---|---|---|---|---|---|---|---|---|---|
| | Color value | | | Light reflectivity (wavelengt h of 1064 nm) | Color value | | | | |
| | L* | a | b | | L* | a | b | | |
| Embodiment 1¹ | 81.44 | -1.03 | 3.11 | 29.88 | 84.24 | -0.25 | 1.29 | 5 | 0 |
| Comparative Embodiment 2 | 69.47 | -2.56 | -0.25 | 34.78 | 69.78 | -2.48 | 0.15 | 3 | 2 |
| Comparative Embodiment 3 | 69.22 | -3.58 | 2.52 | 47.74 | 69.88 | -2.58 | 3.35 | 3 | 3 |
| Comparative Embodiment 4 | 65.44 | -4.32 | -2.58 | 56.78 | / | / | / | / | / |
| Embodiment 2 | 81.44 | -1.03 | 3.11 | 29.88 | 85.66 | -1.25 | 0.55 | 5 | 1 |
| Embodiment 3 | 81.44 | -1.03 | 3.11 | 29.88 | 82.22 | -0.12 | -0.15 | 5 | 1 |
| Embodiment 4² | 81.11 | -2.03 | 2.23 | 21.75 | 83.26 | 1.22 | 4.32 | 5 | 0 |
| Embodiment 5 | 72.72 | -1.76 | 3.64 | 57.52 | 76.51 | -1.56 | 3.12 | 5 | 1 |
| Embodiment 6³ | 85.56 | 1.20 | 2.35 | 22.85 | 87.12 | 2.21 | 2.26 | 5 | 1 |

| | | | | | | | | | |
|---|---|---|---|---|---|---|---|---|---|
| ¹: A PA6T sheet was prepared by the steps of substantially the same with the step 2) of Embodiment 1, with the exception that: only mixed PA6T and antioxidant 1010 to form a third mixture, without the doped tin oxide; and based on 100 weight parts of the PA6T, the amount of the antioxidant 1010 was 10 weight parts. The PA6T sheet has a CIELab color value L* of 83.89, a CIELab color value a of -0.15, and a CIELab color value b of 1.56. ²: A PC sheet was prepared by the steps of substantially the same with the step 2) of Embodiment 4, with the exception that: only mixed PC, antioxidant 1098 and talc to form a third mixture, without the doped tin oxide; and based on 100 weight parts of the PC, the amount of the antioxidant 1098 was 8 weight parts, the amount of the talc was 15 weight parts. The PC sheet has a CIELab color value L* of 83.12, a CIELab color value a of 1.54, and a CIELab color value b of 4.35. ³: A PBT sheet was prepared by the steps of substantially the same with the step 2) of Embodiment 6, with the exception that: only mixed PBT, antioxidant 1098 and talc to form a third mixture, without the doped tin oxide; and based on 100 weight parts of the PBT, the amount of the antioxidant 1098 was 8 weight parts, the amount of the talc was 20 weight parts. The PBT sheet has a CIELab color value L* of 87.55, a CIELab color value a of 2.30, and a CIELab color value b of 2.33. | | | | | | | | | |

It can be seen from Table 1 that, the doped tin oxide obtained from tin oxide doped with niobium-containing element and sintered under an oxidizing atmosphere, had a light color, and had very strong absorption power to light. Thereby, the doped tin oxide was capable of promoting chemical plating in a method of selectively metalizing the surface of the polymer substrate as a chemical plating promoter. Thus presetting the doped tin oxide in the polymer substrate, especially the polymer substrate with light color, does not or basically does not cover the original color of the polymer substrate, further does not obviously interfere the color of the polymer substrate.

Moreover, the polymer substrate irradiated with a laser to remove PA6T on a predetermined part of the surface had a good plating activity. A higher plating speed was obtained and a continuous metal layer was formed without leakage of plating, together with higher adhesive between the metal layer and the polymer substrate while chemical plating.

### Embodiment 7

The present Embodiment includes the following steps.

Step 1) 100 g the doped tin oxide (grinded to powders having an average particle size of 200 nm) obtained from the step 1) of Embodiment 1, 30 g binder CAB381-0.5 (commercially available from Eastman Chemical Company, US), 150 g n-ethanol, 1.5 g dispersing agent DISPERBYK-165 (commercially available from BYK Company, GE), 0.5 g antifoaming agent BYK-051 (commercially available from BYK Company, GE), 0.6 g leveling agent BYK-333 (commercially available from BYK Company, GE) and 0.75 g hydrogenated castor oil (commercially available from Wuhan Jinnuo Chemical Company, China) were mixed uniformly to obtain an ink composition.

Step 2) The ink composition was applied on a surface of an Al₂O₃ ceramic substrate by ink jet printing, and then the Al₂O₃ ceramic substrate applied with the ink composition was dried at a temperature of 100 °C for 3 hours. Thus an ink layer was formed on the surface of the ceramic substrate. The ink layer formed a predetermined pattern and was used as the antenna for a receiver. The ink layer was tested with a scanning electron microscope, and it showed that the ink layer had a thickness of 10 µm.

Step 3) The ink layer was irradiated with a laser, and the laser had a wavelength of 1064 nm, a power of 2 W, a frequency of 20 kHz, a moving speed of 800 mm/s and a filling distance of 20 µm.

Step 4) The ceramic substrate with the irradiated ink layer was subjected to chemical plating for 1 h using a Cu solution containing: 0.12 mol/L of CuSO₄·5H₂O, 0.14 mol/L of Na₂EDTA • 2H₂O, 10 mg/L of potassium ferrocyanide, 10 mg/L of 2,2'-bipyridine and 0.10 mol/L of glyoxylic acid. The Cu solution had a temperature of 50°C and a pH of 12.5-13 which was adjusted with NaOH and H₂SO₄. Therefore a metal layer was formed on the ceramic substrate.

Then the ceramic substrate was observed, and it was found that the metal layer formed a continuous complete circuit on the ceramic substrate. The plating speed and adhesion between the metal layer and the ceramic substrate were both listed in Table 2.

### Embodiment 8

The present embodiment includes substantially the same steps as those of Embodiment 7, with the exception that: the step 3) was not performed, i.e., after the ink layer was applied on the surface of the ceramic substrate, the step of chemical plating was performed directly.

The ceramic substrate was observed, and it was found that the metal layer formed a continuous complete circuit on the ceramic substrate. The plating speed and adhesion between the metal layer and the ceramic substrate were both listed in Table 2.

### Embodiment 9

The present Embodiment includes the following steps.

Step 1) 100 g doped tin oxide (grinded to powders having an average particle size of 100 nm) obtained from the step 1) of Embodiment 4, 45 g polyvinyl butyral Serial No. Mowital (commercially available from Kuraray Company, JP) and 80 g toluene were mixed uniformly to obtain an ink composition.

Step 2) The ink composition was applied on a surface of a poly(ether-ether-ketone) (PEEK) substrate, and then the PEEK substrate applied with the ink composition was dried at a temperature of 120 °C for 6 hours. Thus an ink layer was formed on the surface of the ceramic substrate. The ink layer formed a predetermined pattern and was used as the antenna for a receiver. The ink layer was tested with a scanning electron microscope, and it showed that the ink layer had a thickness of 20 µm.

Step 3) The ink layer was irradiated with a laser, and the laser had a wavelength of 1064 nm, a power of 3 W, a frequency of 20 kHz, a moving speed of 1000 mm/s and a filling distance of 20 µm.

Step 4) The ceramic substrate with the irradiated ink layer was subjected to chemical plating under the same condition as described in the step 4) of Embodiment 7.

Then the ceramic substrate was observed, and it was found that the metal layer formed a continuous complete circuit on the ceramic substrate. The plating speed and adhesion between the metal layer and the ceramic substrate were both listed in Table 2.

### Embodiment 10

The present Embodiment includes the following steps.

Step 1) 100 g the doped tin oxide (grinded to powders having an average particle size of 80 nm) obtained from the step 1) of Embodiment 6, 50 g EVA binder (commercially available from Eastman Chemical Company, US), 200 g toluene, 2 g dispersing agent ANTI-TERRA-U 80, (commercially available from BYK Company, GE), 1 g antifoaming agent BYK-065 (commercially available from BYK Company, GE), 0.8 g leveling agent BYK-306 (commercially available from BYK Company, GE) and 0.6 g hydroxyethyl cellulose (commercially available from Luzhou North Dadong Chemical Company, China) were mixed uniformly to obtain an ink composition.

Step 2) The ink composition was applied on a surface of a glass substrate by ink jet printing, and then the glass substrate applied with the ink composition was dried at a temperature of 150 °C for 4 hours. Thus an ink layer was formed on the surface of the glass substrate. The ink layer formed a predetermined pattern and was used as the antenna for a receiver. The ink layer was tested with a scanning electron microscope, and it showed that the ink layer had a thickness of 15 µm.

Step 3) The glass substrate was irradiated with a laser under the same condition as described in the step 3) of Embodiment 7.

Step 4) The glass substrate irradiated with laser was subjected to a chemical plating under the same condition as described in the step 4) of Embodiment 7.

Then the glass substrate was observed, and it was found that the metal layer formed a continuous complete circuit on the glass substrate. The plating speed and adhesion between the metal layer and the ceramic substrate were both listed in Table 2.

**Table**

| | Plating speed (µm/h) | Adhesion |
|---|---|---|
| Embodiment 7 | 6 | 1 |
| Embodiment 8 | 3 | 2 |
| Embodiment 9 | 5 | 1 |
| Embodiment 10 | 6 | 1 |

It can be seen from Table 2 that, the ink layer formed on the surface of the insulating substrate via an ink jet printing of the ink composition, had a chemical plating activity, and a metal layer was formed on the surface of the ink layer by chemical plating.

## Claims

1. Use of a doped tin oxide as a chemical plating promoter in selectively metallizing a surface of an insulating substrate, wherein a doping element of the doped tin oxide comprises niobium, and the doped tin oxide has a coordinate L* value of 70 to 100, a coordinate a value about -5 to 5, and a coordinate b value of -5 to 5 in a CIELab color space.

2. The use of claim 1, wherein the doped tin oxide has a reflectivity of no more than 60% to a light with a wavelength of 1064 nm.

3. The use of claim 1 or 2, wherein the doped tin oxide has a coordinate L* value of 80 to 90, a coordinate a value of -5 to 2, and a coordinate b value of 2 to 4 in a CIELab color space.

4. The use of any of claims 1 to 3, wherein based on the total weight of the doped tin oxide, the content of the tin oxide is 70wt% to 99.9 wt%, and the content of the niobium is 0.1wt% to 30 wt% calculated as Nb₂O₅.

## Patentansprüche

1. Verwendung eines dotierten Zinnoxids als chemischer Plattierungsförderer bei der selektiven Metallisierung einer Oberfläche eines isolierenden Substrats, wobei ein Dotierungselement des dotierten Zinnoxids Niob umfasst und das dotierte Zinnoxid einen Koordinatenwert L* von 70 bis 100, einen Koordinatenwert a von etwa -5 bis 5 und einen Koordinatenwert b von -5 bis 5 in einem CIELab-Farbraum aufweist.

2. Verwendung nach Anspruch 1, wobei das dotierte Zinnoxid einen Reflexionsgrad von nicht mehr als 60 % für ein Licht mit einer Wellenlänge von 1064 nm hat.

3. Verwendung nach Anspruch 1 oder 2, wobei das dotierte Zinnoxid einen Koordinatenwert L* von 80 bis 90, einen Koordinatenwert a von -5 bis 2 und einen Koordinatenwert b von 2 bis 4 in einem CIELab-Farbraum aufweist.

4. Verwendung nach einem der Ansprüche 1 bis 3, wobei auf der Basis des Gesamtgewichts des dotierten Zinnoxids der Gehalt des Zinnoxids 70 Gew.-% bis 99,9 Gew.-% beträgt, und der Gehalt des Niobs ist 0,1 Gew.-% bis 30 Gew.-%, berechnet als Nb₂O₅.

## Revendications

1. Utilisation d'un oxyde d'étain dopé en tant que promoteur de placage chimique dans la métallisation sélective d'une surface d'un substrat d'isolation, dans laquelle un élément de dopage de l'oxyde d'étain dopé comprend du niobium, et l'oxyde d'étain dopé a une valeur de coordonnées L* comprise entre 70 et 100, une valeur de coordonnées a comprise entre environ -5 et 5, et une valeur de coordonnées b comprise entre -5 et 5 dans un espace de couleur de type CIELab.

2. Utilisation selon la revendication 1, dans laquelle l'oxyde d'étain dopé à une réflexivité inférieure ou égale à 60 % à une lumière ayant une longueur d'onde de 1064 nm.

3. Utilisation selon la revendication 1 ou la revendication 2, dans laquelle l'oxyde d'étain dopé a une valeur de coordonnées L* comprise entre 80 et 90, une valeur de coordonnées a comprise entre environ -5 et 2, et une valeur de coordonnées b comprise entre 2 et 4 dans un espace de couleur de type CIELab.

4. Utilisation selon l'une quelconque des revendications 1 à 3, dans laquelle en fonction du poids total de l'oxyde d'étain dopé, la teneur en oxyde d'étain est comprise entre 70 % en poids et 99,9 % en poids, et la teneur en niobium est comprise entre 0,1 % en poids et 30 % en poids calculée en tant que Nb₂O₅.
